**Europäisches Patentamt**

**European Patent Office**

**Office européen des brevets**

(11) Veröffentlichungsnummer: **0 366 999**

**A1**

## (12) EUROPÄISCHE PATENTANMELDUNG

(21) Anmeldenummer: **89119099.3**

(22) Anmeldetag: **14.10.89**

(51) Int. Cl.5: **G01R 35/02**

(30) Priorität: **02.11.88 CH 4077/88**

(43) Veröffentlichungstag der Anmeldung:
**09.05.90 Patentblatt 90/19**

(84) Benannte Vertragsstaaten:
**CH DE FR GB LI SE**

(71) Anmelder: **ASEA BROWN BOVERI AG**
**Haselstrasse**
**CH-5401 Baden(CH)**

(72) Erfinder: **Hansen, Diethard, Dr.**
**Bahnhofstrasse 39a**
**CH-8965 Berikon(CH)**
Erfinder: **Köster, Dieter**
**Allmendstrasse 30**
**CH-5300 Turgi(CH)**

(54) **Vorrichtung zum Eichen und Prüfen von ringförmigen Stromzangen.**

(57) Eine Vorrichtung zum Eichen und Prüfen von ringförmigen Stromzangen umfasst ein Eichgehäuse (1) mit einem die Stromzange (2) umschliessenden Aussenleiter (3a,3b) und einen durch die Stromzange (2) hindurchführenden Innenleiter (5a,5b). Der Aussenleiter (3a,3b) umschliesst die Stromzange (2) allseitig und ist an die Form der Stromzange (2) angepasst. Das Eichgehäuse (1) weist ferner mit der darin untergebrachten Stromzange (2) eine durch ein Messsystem vorgegebene Impedanz $Z_L$ auf. Durch diese Massnahmen ist es möglich, den Frequenzgang der Stromzange bis in den GHz Bereich präzise auszumessen.

Gemäss einer bevorzugten Ausführungsform weist das Eichgehäuse (1) auf die Anschlüsse (6,7) hin konisch zusammenlaufende Uebergänge auf.

EP 0 366 999 A1

# Vorrichtung zum Eichen und Prüfen von ringförmigen Stromzangen

## Technisches Gebiet

Die Erfindung betrifft eine Vorrichtung zum Eichen und Prüfen von ringförmigen Stromzangen, umfassend ein Eichgehäuse mit einem die Stromzange umschliessenden Aussenleiter und einen durch die Stromzange hindurchführenden Innenleiter.

## Stand der Technik

Stromzangen können eingeteilt werden in Messzangen und Stromeinspritzzangen. Messzangen wirken als Stromwandler und Stromeinspritzzangen als Transformator mit einer Sekundärwicklung. Sie werden hauptsächlich auf den Gebieten EMC, EMP, Blitztest, ESD sowie EMI-Control verwendet.

Stromzangen sind sehr empfindlich auf Ueberlastung. Bei zu grossen Strömen können die eingebauten Abschlusswiderstände leicht zerstört oder, schlimmer, beschädigt werden. Beschädigte Widerstände sind nicht leicht zu erkennen und verfälschen unter Umständen unbemerkt die Messungen.

Im Sinn einer Qualitätskontrolle ist es deshalb wichtig, den Frequenzgang solcher Stromzangen messen zu können. Für diese Zwecke bietet nun beispielsweise die Firma EATON CORPORATION, 5340 Alla Road, Los Angelos CA 90066, ein sogenanntes Calibration Jig an. Diese Vorrichtung besteht im wesentlichen aus einem offenen Gehäuse und einem Innenleiter, welcher beim Prüfen durch die Stromzange umschlossen ist. Messungen haben nun aber gezeigt, dass diese Testeinrichtung für höhere Frequenzen von einigen hundert MHz bis 1 GHz unbrauchbar ist.

## Darstellung der Erfindung

Aufgabe der Erfindung ist es, eine Vorrichtung zum Eichen und Prüfen von ringförmigen Stromzangen, umfassend ein Eichgehäuse mit einem die Stromzange umschliessenden Aussenleiter und einen durch die Stromzange hindurchführenden Innenleiter, zu schaffen, mit welcher der Frequenzgang im HF-Bereich exakt gemessen werden kann.

Erfindungsgemäss besteht die Lösung darin, dass bei einer Vorrichtung der eingangs genannten Art der Aussenleiter die Stromzange allseitig umschliesst und an die Form der Stromzange angepasst ist, und dass das Eichgehäuse mit der darin untergebrachten Stromzange eine durch ein Messsystem vorgegebene Impedanz aufweist.

Der Kern der Erfindung liegt darin, dass die zu prüfende Stromzange vollständig von der Aussenwelt abgeschlossen ist. Das Eichgehäuse mit der darin untergebrachten Stromzange besitzt an jeder Stelle eine an die umgebende Messeinrichtung angepasste Impedanz. Ein Messsignal nimmt dadurch nur die durch die Stromzange erzeugte Störung wahr. Erst durch die Erfindung ist es also möglich geworden, den Frequenzgang bis hinauf zu 1 GHz genau zu messen. Es ergeben sich damit Vorteile

1. für die Qualitätssicherung,
2. für die Fehlerkorrektur bei hochpräzisen Messungen,
3. für die optimale Nutzung der Stromzangen (d.h. bis zur maximalen individuellen Belastungsgrenze) und
4. für das Erkennen von Beschädigungen.

Vorteilhafte Ausführungsformen der Erfindung ergeben sich aus den abhängigen Patentansprüchen.

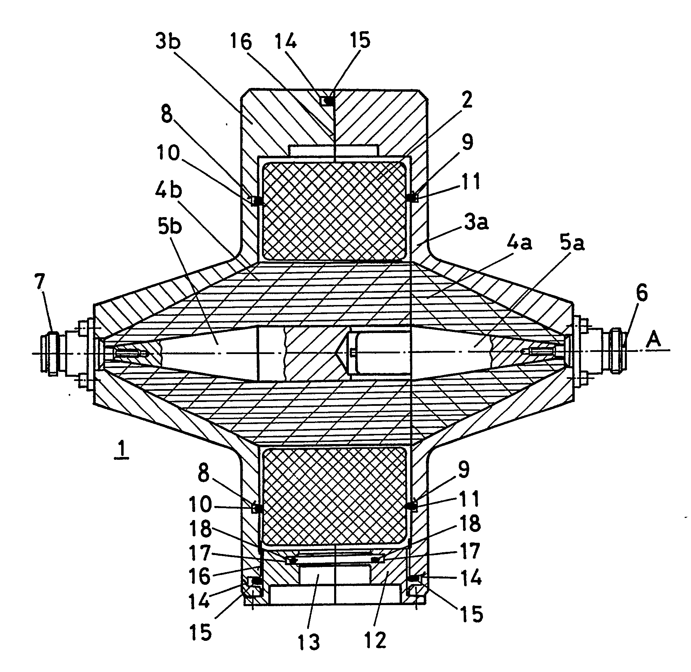

## Kurze Beschreibung der Zeichnung

Nachfolgend soll die Erfindung anhand von Ausführungsbeispielen und im Zusammenhang mit der Zeichnung näher erläutert werden. Die einzige Figur zeigt einen Längsschnitt eines erfindungsgemässen Eichgehäuses mit darin untergebrachter Stromzange.


## Wege zur Ausführung der Erfindung


In der einzigen Figur ist ein Längsschnitt durch ein Eichgehäuse 1 gezeigt. Dieses besteht gemäss einer bevorzugten Ausführungsform aus zwei in axialer Richtung zusammenfügbaren Hälften. Entsprechend setzen sich gewisse elektrischen Elemente des Eichgehäuses 1 aus zwei Teilen zusammen. In der Figur sind die jeweils zusammengehörenden Teile durch hinter das Bezugszeichen gestellte Kleinbuchstaben a und b bezeichnet.

Das Eichgehäuse 1 ist mechanisch an die Bauform eines zu prüfenden Typs einer Stromzange 2 angepasst.

Die Stromzange ist nicht Teil der Erfindung, sondern z.B. eine handelsübliche Messzange für Hochfrequenzanwendungen. Sie ist ringförmig und hat z.B. ein Scharnier und einen Verschlussmechanismus, sodass sie zangenförmig um einen elektrischen Leiter gelegt werden kann. An der Aussenseite ist ein Anschluss, z.B. eine Normbuchse, angebracht.

Das Eichgehäuse 1 umfasst einen Aussenleiter 3a,3b, einen Isolator 4a,4b und einen Innenleiter 5a,5b. Es ist näherungsweise rotationssymmetrisch bezüglich einer Achse A. Auf dieser Achse A sind an jeweils gegenüberliegenden Enden des Eichgehäuses 1 zwei Anschlüsse 6 und 7 vorgesehen.

Der Aussenleiter 3a,3b umschliesst die Stromzange 2 vollständig. Er ist ausserdem an die äussere Form derselben angepasst. Der Innenleiter 5a,5b ist durch die Stromzange 2 hindurchgeführt. Zwischen Innenleiter 5b und Stromzange 2 ist der Isolator 4b angeordnet.

Innerhalb der Stromzange 2 sind Innenleiter 5b und Isolator 4b zylinderförmig. Der Isolator 4b hat einen Aussendurchmesser D, welcher exakt dem inneren Durchmesser der Stromzange entspricht, einen Innendurchmesser d, welcher exakt dem Durchmesser des Innenleiters 5b entspricht, und eine Dielektrizitätskonstante $\epsilon_r$. Diese drei Grössen erfüllen die folgende Beziehung:

$$Z_L = \frac{60}{\sqrt{\epsilon_r}} \ln \frac{D}{d} \qquad (I)$$

$Z_L$ ist eine durch ein Messsystem vorgegebene Impedanz (z.B. $Z_L$ = 50 Ohm).

Der Isolator 4a,4b zentriert den Innenleiter 5a,5b bezüglich der ringförmigen Stromzange 2. Er sollte aus einem Material bestehen, welches genügend fest ist. Damit der Innendurchmesser d und folglich der Innenleiter 5a,5b möglichst klein ist, wird die Dielektrizitätskonstante $\epsilon_r$ vorzugsweise in der Grössenordnung von Eins gewählt. Teflon ist in diesem Sinn vorteilhaft. Ebenso "schaumartige" Materialien, d.h. Materialien die viel Luft enthalten, wie z.B. Styropor.

Die beiden axial angeordneten Anschlüsse 6 und 7 sind beispielsweise Normstecker für Koaxialkabel. Im allgemeinen sind deshalb der innere Durchmesser der Stromzange 2 und der Durchmesser des Innenleiters 5a,5b grösser als die entsprechenten Abmessungen des Normsteckers. Gemäss der Erfindung ist in diesem Fall für jeden Anschluss 6,7 ein Uebergang vorgesehen. In diesem laufen jeweils Innen- und Aussenleiter auf einer Länge L vom axialen Bereich der Stromzange 2 zu den Anschlüssen 6,7 hin konisch zusammen. Wichtig ist dabei, dass die Beziehung (I) an jeder Stelle des Uebergangs eingehalten ist. (Anstelle des maximalen Aussendurchmessers D tritt dann in der Formel (I) ein lokaler Aussendurchmesser. Entsprechendes gilt für den Innendurchmesser d.)

Je kleiner der Neigungswinkel, d.h. das Verhältnis von Aussendurchmesser D zu Länge L ist, desto besser ist der Uebergang und desto weniger wirken sich mechanische Ungenauigkeiten der Bauteile aus. Andrerseits ist es aus ökonomischen Gründen wünschenswert, das Eichgehäuse möglichst klein zu halten. Es hat sich nun gezeigt, dass es vorteilhaft ist, die Länge L etwa gleich gross wie den Aussendurchmesser D zu wählen. Vorzugsweise ist die Länge L mindestens so gross wie der maximale Aussendurchmesser D.

Die Stromzange 2 muss vom Aussenleiter 3a,3b elektrisch isoliert sein. Gleichzeitig soll sie mechanisch gut fixiert sein. Gemäss einer bevorzugten Ausführungsform der Erfindung wird das so erreicht, dass jede Hälfte des Aussenleiters 3a resp. 3b eine ringförmige Nut 8 resp 9 aufweist, in welche ein elastischer O-Ring 10 resp. 11 eingelegt ist. Der Aussenleiter 3a,3b kontaktiert die Stromzange 2 an genau einer Stelle. und zwar an ihrem Anschluss 13. Eine Nut 17 und ein darin eingelegtes elastisches, drahtumwickeltes Band 18 sichern den elektrischen Kontakt.


3

Für den zu Beginn erwähnten Anschluss 13 der Stromzange 2 ist am Aussenleiter 3a,3b eine Blende 12 eingelassen.

Die beiden Hälften des Eichgehäuses müssen so aneinandergefügt sein, dass ein einwandfreier elektrischer Kontakt gewährleistet ist. Beim Innenleiter 5a,5b wird das am einfachsten mit einem Steckkontakt erreicht. Beim Aussenleiter 3a,3b wird vorzugsweise eine der Hälften an einer Kontaktfläche 16 mit einer umlaufenden Nut 14 versehen, in die ein elastisches drahtumwickeltes Band 15 (z.B. ein mit einem Drahtgeflecht umwickelter Gummiring, genannt Gasket) eingelegt ist.

Wenn das Eichgehäuse gemäss einer vorteilhaften Ausführungsform aus Aluminium gefertigt ist, dann wird die Kontaktfläche zudem noch mit einer gutleitenden Schicht (z.B. aus Silber) bedeckt.

Das erfindungsgemässe Eichgehäuse hat natürlich je nach Bauform der zu prüfenden Stromzange andere Abmessungen. Bei kleinen Stromzangen kann unter Umständen der konische Uebergang entfallen.

Dass das Eichgehäuse aus zwei axial zusammenfügbaren Hälften besteht, ist nicht so wichtig. In der Praxis ist einfach darauf zu achten, dass die Massnahmen, die die Zerlegung des Gehäuses erlauben, keine Störungen der Impedanz induzieren und sich in der Testvorrichtung keine unzulässigen Wellenmoden ausbreiten.

Abschliessend kann gesagt werden, dass die Erfindung eine mechanisch einfache Vorrichtung schafft, mit welcher Stromzangen auch im HF-Bereich elektrisch qualifiziert werden können.

**Ansprüche**

1. Vorrichtung zum Eichen und Prüfen von ringförmigen Stromzangen, umfassend
   a) ein Eichgehäuse mit einem die Stromzange umschliessenden Aussenleiter und
   b) einen durch die Stromzange hindurchführenden Innenleiter,
dadurch gekennzeichnet, dass
   c) der Aussenleiter (3a,3b) die Stromzange (2) allseitig umschliesst und an die Form der Stromzange (2) angepasst ist, und dass
   d) das Eichgehäuse (1) mit der darin untergebrachten Stromzange (2) eine durch ein Messsystem vorgegebene Impedanz $Z_L$ aufweist.

2. Vorrichtung nach Anspruch 1, dadurch gekennzeichnet, dass
   a) zwischen Innenleiter (5a,5b) und Stromzange (2) ein Isolator (4a,4b) angeordnet ist, welcher den Innenleiter (5a,5b) in bezug auf die Stromzange (2) zentriert, und dass
   b) ein Innendurchmesser d, ein Aussendurchmesser D und eine Dielektrizitätskonstante $\epsilon_r$ des Isolators (4a,4b) die folgende Beziehung erfüllen:

$$Z_L = \frac{60}{\sqrt{\epsilon_r}} \ln \frac{D}{d}$$

wobei $Z_L$ die gegebene Impedanz des Messsystems bezeichnet.

3. Vorrichtung nach Anspruch 1, dadurch gekennzeichnet, dass
   a) das Eichgehäuse (1) zwei axial angeordnete Anschlüsse (6,7) aufweist, und dass
   b) Innenleiter (5a,5b) und Aussenleiter (3a,3b) des Eichgehäuses (1) in axialer Richtung auf einer Länge L zu den Anschlüssen (6,7) hin konisch zusammenlaufen.

4. Vorrichtung nach Anspruch 3, dadurch gekennzeichnet, dass die Länge L zumindest so gross wie der maximale Aussendurchmesser D des Isolators (4a,4b) ist.

5. Vorrichtung nach Anspruch 1, dadurch gekennzeichnet, dass die Dielektrizitätskonstante $\epsilon_r$ des Isolators (4a,4b) in der Grössenordnung von Eins liegt.

6. Vorrichtung nach Anspruch 1, dadurch gekennzeichnet, dass das Eichgehäuse (1) aus zwei formschlüssigen Hälften mit je einer Kontaktfläche besteht, welche sich in axialer Richtung aneinanderfügen lassen.

7. Vorrichtung nach Anspruch 6, dadurch gekennzeichnet, dass die Stromzange (2) mittels isolierender elastischer O-Ringe (10,11) vom Aussenleiter (3a,3b) fixiert wird und der Aussenleiter (3a,3b) die Stromzange (2) nur an ihrem Anschluss (13) kontaktiert.

8. Vorrichtung nach Anspruch 6, dadurch gekennzeichnet, dass der Aussenleiter (3a,3b) aus Aluminium und der Isolator (4a,4b) aus Teflon oder Styropor besteht.

9. Vorrichtung nach Anspruch 6, dadurch gekennzeichnet, dass zur Verbesserung des elektrischen Kontakts zwischen den beiden Hälften auf einer Kontaktfläche (16) eine umlaufende Nut (14) vorgesehen ist, in welche ein drahtumwickeltes, elastisches Band (15) eingelegt ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | SIEMENS COMPONENTS, Band 20, Nr. 6, Dezember 1985, Seiten 237-240, Berlin, DE; H.-A. FRITSCHE: "Measuring methods for testing the screening efficiency of plug connectors"<br>--- | | G 01 R 35/02 |
| A | IEEE TRANSACTIONS ON POWER APPARATUS AND SYSTEMS, Band PAS-90, Nr. 1, Januar/Februar 1971, Seiten 318-324; T.M. SOUNDERS: "A wide range current comparator system for calibrating current transformers"<br>----- | | |
| | | | **RECHERCHIERTE SACHGEBIETE (Int. Cl.5)**<br><br>G 01 R |

Der vorliegende Recherchenbericht wurde für alle Patentansprüche erstellt

| Recherchenort | Abschlußdatum der Recherche | Prüfer |
|---|---|---|
| DEN HAAG | 29-11-1989 | HOORNAERT W. |